Europäisches Patentamt

European Patent Office

Office européen des brevets

(19)

(11) EP 0 658 772 B1

(12) FASCICULE DE BREVET EUROPEEN

(45) Date de publication et mention
de la délivrance du brevet:
13.03.2002 Bulletin 2002/11

(51) Int Cl.⁷: $G01R\ 33/09$

(21) Numéro de dépôt: 94402841.4

(22) Date de dépôt: 09.12.1994

(54) **Capteur magnétique à effet magnéto-résistif**

Magnetischer Fühler mit magnetoresistivem Effekt

Magnetic sensor with magnetoresistive effect

(84) Etats contractants désignés:
**DE GB NL**

(30) Priorité: **14.12.1993 FR 9314992**

(43) Date de publication de la demande:
**21.06.1995 Bulletin 1995/25**

(73) Titulaire: **Thales**
**75008 Paris (FR)**

(72) Inventeurs:
• **Coutellier, Jean-Marc**
**F-92402 Courbevoie Cedex (FR)**
• **Blanchard, Nicolas**
**F-92402 Courbevoie Cedex (FR)**
• **Valet, Thierry**
**F-92402 Courbevoie Cedex (FR)**

(74) Mandataire: **Guérin, Michel et al**
**Thomson-CSF Propriété Intellectuelle,**
**13, Avenue du Président Salvador Allende**
**94117 Arcueil Cédex (FR)**

(56) Documents cités:
**EP-A- 0 534 791**          **WO-A-92/01945**
**GB-A- 2 169 434**

## Description

La présente invention concerne les capteurs magnétiques à effet magnéto-résistif et plus particulièrement les capteurs magnétiques à effet magnéto-résistif nécessitant de collecter le champ magnétique à détecter à l'aide de pièces polaires comme il est connu du docuement WO-A-92 01945. De tels capteurs sont utilisés, par exemple, comme têtes de lecture ou comme magnétomètres. Ils sont de type monocouche ou de type multicouches. La présente invention sera plus particulièrement décrite pour les capteurs de type monocouche. Cependant, comme cela apparaîtra ultérieurement, la présente invention concerne aussi les capteurs de type multicouches.

Les capteurs magnétiques à effet magnéto-résistif, communément appelé par la suite capteurs magnéto-résistifs, utilisent le phénomène selon lequel la valeur de la résistance ohmique de certains matériaux varie en fonction de l'intensité du champ magnétique qui leur est appliqué. La variation de la résistance, détectée à l'aide de méthodes usuelles, permet alors de mesurer la variation du champ magnétique.

De façon générale, les capteurs magnéto-résistifs selon l'invention, comprennent un élément à effet magnéto-résistif parcouru par un courant et deux pièces polaires.

Comme cela a été mentionné précédemment, ces deux pièces polaires permettent de collecter le champ magnétique à détecter.

Comme cela est connu de l'homme de l'art, la variation de la résistivité $\rho$ d'un matériau sensible à l'effet magnéto-résistif en fonction de l'angle $\alpha$ que font entre elle la direction du courant I parcourant ce matériau et la direction de l'aimantation du matériau est donnée par la formule :

$$\rho = \rho_o(1 + \frac{\Delta\rho}{\rho_o}\cos^2\alpha)$$

où $\rho_o$ est la résistivité du matériau en l'absence de champ magnétique.

La variation de résistivité et, partant, la variation de résistance sont alors maximales pour $\alpha = 45°$.

C'est dans ces conditions que sont utilisés les capteurs magnéto-résistifs destinés à présenter une sensibilité élevée de détection des variations du champ magnétique.

Selon l'art antérieur, les deux pièces polaires recouvrent partiellement l'élément à effet magnéto-résistif.

Ce recouvrement est réalisé afin que la transmission du flux magnétique vers l'élément à effet magnéto-résistif soit la meilleure possible.

Un tel dispositif présente cependant des inconvénients. Le champ magnétique ne se trouve principalement concentré que dans la zone de l'élément à effet magnéto-résistif comprise dans l'entrefer des deux pièces polaires. Or, le courant qui parcourt cet élément se répartit uniformément dans celui-ci. Il s'en suit une perte de sensibilité par rapport à celle qui pourrait être espérée.

La présente invention ne présente pas cet inconvénient.

La présente invention a pour objet un capteur magnétique à effet magnéto-résistif caractérisé en ce que les zones de l'élément à effet magnéto-résistif qui sont en recouvrement avec les pièces polaires sont découpées ou crénelées de façon à localiser le courant qui parcourt l'élément à effet magnéto-résistif dans une zone qui se trouve dans l'entrefer situé entre les deux pièces polaires.

Le document GB-A-2 169 434 décrit un capteur avec un élément magnéto-résistif qui a des bords avec une succession de créneaux. Le capteur connu n'a pas de pièces polaires qui concentrent le champ magnétique dans un entrefer. Les créneaux servent à un guidage du flux qui augmente l'anisotropie de forme de l'élément magnéto-résistif.

Un avantage de l'invention est donc l'amélioration de la sensibilité des capteurs magnéto-résistifs nécessitant de collecter le champ magnétique à détecter à l'aide de pièces polaires.

D'autres caractéristiques et avantages de l'invention apparaîtront à la lecture d'un mode de réalisation préférentiel fait avec référence aux figures ci-annexées dans lesquelles :

- les figures 1A et 1B représentent respectivement la vue en coupe et la vue de dessus d'un capteur magnéto-résistif selon l'art antérieur,
- la figure 2 représente la vue de dessus d'un capteur magnéto-résistif selon l'invention.

Sur toutes les figures, les mêmes repères désignent les mêmes éléments.

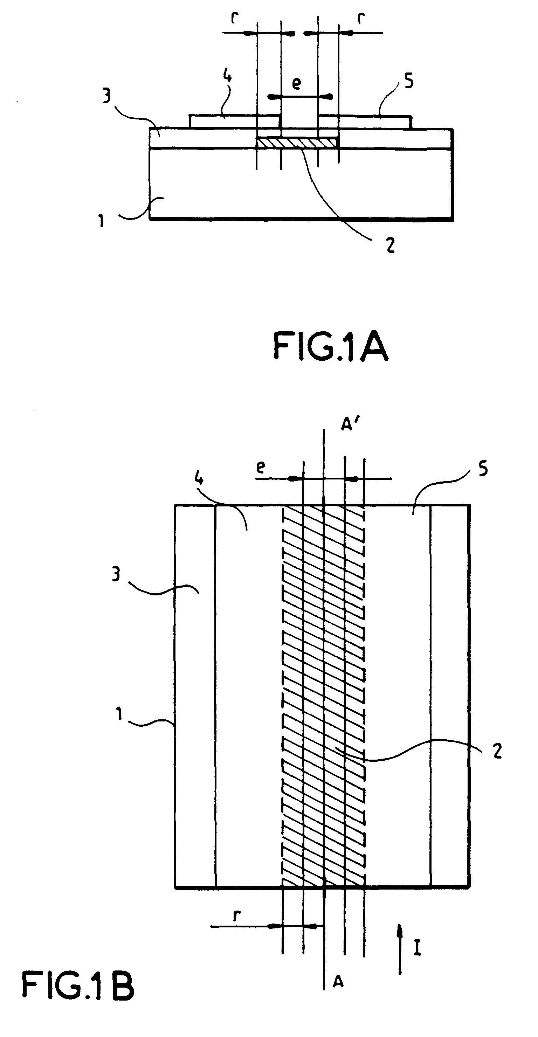

La figure 1A et 1B représentent respectivement la vue en coupe et la vue de dessus d'un capteur magnéto-résistif selon l'art antérieur. Sur ces figures, un élément à effet magnéto-résistif 2 est situé sur un support matériel 1. Le dépôt de cet élément peut être effectué, par exemple par pulvérisation cathodique.

L'épaisseur de l'élément à effet magnéto-résistif peut être, par exemple, de l'ordre de 25 nanomètres. Une couche isolante 3, par exemple une couche d'oxyde métallique, recouvre entièrement l'ensemble constitué par l'élément à effet magnéto-résistif et le support matériel. Deux pièces polaires 4 et 5 sont déposées sur la couche isolante 3. Les pièces polaires sont réalisées, de préférence, en matériau magnétique doux, par exemple en alliage de Sendust. Comme cela a été mentionné précédemment, chacune des deux pièces polaires recouvre partiellement, sur une distance r l'élément à effet magnéto-résistif de façon à améliorer la transmission du flux magnétique vers cet élément. Les deux pièces polaires, de forme préférentiellement rectangulaire, sont disposées parallèlement l'une à l'autre. La distance qui les sépare, notée e, constitue l'entrefer du capteur magnéto-résistif. L'élément à effet magnéto-résistif 2 est parcouru par le courant I. Ce courant circule suivant l'axe AA' que définit l'entrefer. En l'absence de variation de champ magnétique, l'élément 2 présente la résistance R. La tension détectée s'écrit alors V = RI. En présence de variation du champ magnétique, la résistance de l'élément à effet magnéto-résistif varie. La variation de la tension détectée alors donnée par la formule $\Delta V = \Delta R \times I$ ou $\Delta R$ représente la variation de résistance de l'élément à effet magnéto-résistif.

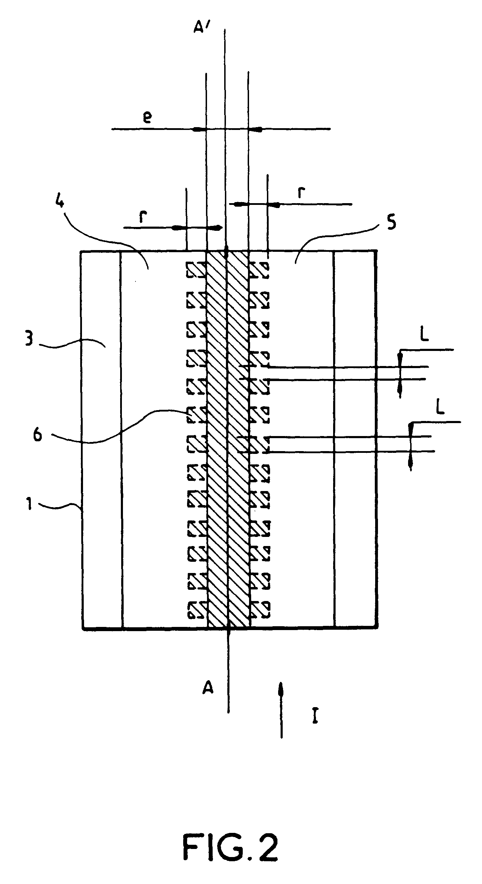

La figure 2 représente la vue de dessus d'un capteur magnéto-résistif selon l'invention.

L'élément magnéto-résistif 2 est alors crénelé. Les deux parties de l'élément à effet magnéto-résistif qui sont en recouvrement avec les pièces polaires sur la distance r sont constituées, chacune, d'une succession de créneaux 6.

Selon l'invention, les créneaux 6 sont agencés de façon que le courant I ne s'écoule que dans la zone de l'élément à effet magnéto-résistif située dans l'entrefer. De façon préférentielle, les créneaux sont de largeur L et l'espacement situé entre deux créneaux successifs est aussi de largeur L. Cependant, toute autre configuration conduisant à confiner le courant dans la zone de l'élément magnéto-résistif située dans l'entrefer relève de l'invention.

Le dispositif selon l'invention permet donc de ne localiser le courant que dans la zone où se concentre le champ magnétique.

Avantageusement, la sensibilité du capteur magnéto-résistif s'en trouve améliorée. A titre d'exemple, un capteur magnéto-résistif selon l'invention, dont l'entrefer e est égal à 100 microns et dont le recouvrement r est égal à 10 microns, présente un gain de sensibilité de l'ordre de 20 % par rapport à un capteur magnéto-résistif selon l'art antérieur, c'est-à-dire dépourvu de créneaux. Les zones de recouvrement r n'étant parcourues par aucun courant, un autre avantage de l'invention consiste alors à pouvoir étendre ces zones de façon à mieux collecter le champ magnétique.

Préférentiellement le procédé de fabrication d'un dispositif selon l'invention comprend les principales étapes suivantes :

- Dépôt du matériau magnéto-résistif par pulvérisation cathodique sur la surface du support 1. Comme cela a été mentionné précédemment, l'épaisseur du dépôt peut être, par exemple, égale à 25 manomètres.
- Mise en place d'un masque, par exemple en résine photosensible, sur la couche de matériau magnéto-résistif. Ce masque a la forme que doit prendre l'élément magnéto-résistif final. La largeur L peut, par exemple, être égale à 10 microns.
- Retrait de la couche magnéto-résistive là où elle n'est pas désirée.
- Retrait du masque.
- Dépôt d'une couche isolante 3, par exemple une couche d'oxyde métallique, par tout moyen connu de l'homme de l'art. L'épaisseur de la couche isolante peut être, par exemple, égale à 200 nanomètres.
- Dépôt d'une couche de matériau magnétique doux ou d'alliage de Sendust sur la totalité de la couche isolante précédemment déposée.
- Mise en place d'un masque aux dimensions des pièces polaires.
- Gravure des pièces polaires.

Dans le cas de la fabrication d'une tête de lecture, le masque mis en place pour définir les pièces polaires est enlevé afin que le champ magnétique inscrit sur la bande lue puisse être détecté dans les meilleures conditions. Par contre, dans le cas de la fabrication d'un magnétomètre, le masque peut demeurer puisque le champ à détecter est présent partout dans l'espace environnant.

Comme cela a été mentionné précédemment, l'invention concerne aussi les capteurs magnéto-résistifs du type multicouches. Comme cela est connu de l'homme de l'art, l'élément magnéto-résistif est alors constitué par un empilement d'au moins deux couches magnétiques séparées par une couche non magnétique. Dans le procédé de fabrication décrit précédemment, la première étape consiste alors à déposer les couches successives nécessaires à la constitution de l'élément magnéto-résistif.

Dans le mode de réalisation préférentiel décrit ci-dessus, l'élément magnéto-résistif n'est crénelé que là où il y a recouvrement de l'élément avec les pièces polaires. Selon d'autres modes de réalisation l'élément magnéto-résistif est crénelé jusque dans la zone située dans l'entrefer.

## Revendications

1. Capteur magnétique à effet magnéto-résistif comprenant un élément à effet magnéto-résistif (2) dont la résistance varie en fonction du champ magnétique appliqué et deux pièces polaires (4,5) permettant de collecter le champ magnétique à détecter de façon à le concentrer dans l'élément à effet magnéto-résistif (2), chaque pièce polaire étant positionnée de façon à recouvrir partiellement l'élément magnéto-résistif (2), ledit élément à effet magnéto-résistif étant parcouru par un courant I, **caractérisé en ce que** les zones de l'élément à effet magnéto-résistif (2) qui sont en recouvrement avec les pièces polaires sont crénelées de façon que le courant qui parcourt l'élément à effet magnéto-résistif soit localisé dans une zone qui se trouve dans l'entrefer situé entre les deux pièces polaires.

2. Capteur magnétique selon la revendication 1, **caractérisé en ce que** lesdites zones sont constituées d'une succession de créneaux (6).

3. Capteur magnétique selon la revendication 2, **caractérisé en ce que** les créneaux (6) et l'espacement séparant deux créneaux ont la même largeur (L).

4. Capteur magnétique selon l'une quelconque des revendications précédentes **caractérisé en ce que** l'élément à effet magnéto-résistif (2) est constitué d'un seul matériau.

5. Capteur magnétique selon l'une quelconque des revendications 1 à 3, **caractérisé en ce que** l'élément à effet magnéto-résistif (2) est constitué par empilement d'au moins deux couches magnétiques séparées par une couche non magnétique.

**Patentansprüche**

1. Magnetischer Aufnehmer mit magnetoresistiver Wirkung, mit einem Element (2) mit magnetoresistiver Wirkung, dessen Widerstand sich in Abhängigkeit von dem angelegten Magnetfeld ändert, und zwei Polstücken (4, 5), die ermöglichen, das zu erfassende Magnetfeld derart einzufangen, daß es in dem Element (2) mit magnetoresistiver Wirkung konzentriert wird, wobei jedes Polstück in der Weise angeordnet ist, daß es das magnetoresistive Element (2) teilweise bedeckt, wobei das Element mit magnetoresistiver Wirkung von einem Strom I durchflossen wird, **dadurch gekennzeichnet, daß** die Zonen des Elements (2) mit magnetoresistiver Wirkung, die mit den Polstücken überlappen, in der Weise eingeschnitten sind, daß der Strom, der durch das Element mit magnetoresistiver Wirkung fließt, in einer Zone lokalisiert wird, die sich in dem zwischen den beiden Polstücken befindlichen Luftspalt befindet.

2. Magnetischer Aufnehmer nach Anspruch 1, **dadurch gekennzeichnet, daß** die Zonen aus einer Folge von Zacken (6) gebildet sind.

3. Magnetischer Aufnehmer nach Anspruch 2, **dadurch gekennzeichnet, daß** die Zacken (6) und der jeweils zwei Zacken trennende Zwischenraum die gleiche Breite (L) besitzen.

4. Magnetischer Aufnehmer nach einem der vorhergehenden Ansprüche, **dadurch gekennzeichnet, daß** das Element (2) mit magnetoresistiver Wirkung auf einem einzigen Werkstoff gebildet ist.

5. Magnetischer Aufnehmer nach einem der Ansprüche 1 bis 3, **dadurch gekennzeichnet, daß** das Element (2) mit magnetoresistiver Wirkung durch Stapeln wenigstens zweier magnetischer Schichten, die durch eine nichtmagnetische Schicht getrennt sind, gebildet ist.

**Claims**

1. Magnetic sensor with magneto-resistive effect, comprising an element with magneto-resistive effect (2), the resistance of which varies as a function of the applied magnetic field, and two pole pieces (4, 5) enabling collection of the magnetic field to be detected so as to concentrate it in the magneto-resistive element (2), each pole piece being positioned so as to partly overlap the magneto-resistive element (2), said element with magneto-resistive effect being passed through by a current I, **characterized in that** the zones of the element with magneto-resistive effect (2) which are overlapped by the pole pieces are cut into so that the current which passes through the magneto-resistive element is localized in a zone located in the air gap between the two pole pieces.

2. Magnetic sensor according to Claim 1, **characterized in that** said zones consist of a succession of castellations (6).

3. Magnetic sensor according to Claim 2, **characterized in that** the castellations (6) and the spacing separating two castellations have the same width (L).

4. Magnetic sensor according to any one of the preceding claims, **characterized in that** the element with magneto-resistive effect (2) is made of a single material.

5. Magnetic sensor according to any one of Claims 1 to 3, **characterized in that** the element with magneto-resistive effect (2) is made by stacking at least two magnetic layers separated by a non-magnetic layer.

# FIG.1A

# FIG.1B

FIG.2